# EUROPÄISCHE PATENTSCHRIFT

(11) **EP 1 810 986 B1**
(45) Veröffentlichungstag und Bekanntmachung des Hinweises auf die Patenterteilung: **27.06.2012**
(21) Anmeldenummer: 07000668.9
(22) Anmeldetag: 15.01.2007
(51) Int. Cl.: C08G 61/12, C08L 65/00, C09K 11/06, H05B 33/14

(54) **Polythiophenformulierungen zur Verbesserung von organischen Leuchtdioden**
Polythiophene formulations for improving organic LEDs
Formules de polythiophène destinées à l'amélioration de diodes luminescentes organiques

(30) Priorität: 20.01.2006 DE 102006002798
(43) Veröffentlichungstag der Anmeldung: 25.07.2007
(73) Patentinhaber: Heraeus Precious Metals GmbH & Co. KG, 63450 Hanau (DE)
(72) Erfinder: Elschner, Andreas, 45479 Mühlheim (DE); Reuter, Knud, 47800 Krefeld (DE); Lövenich, Peter Wilfried Dr., 51469 Bergisch-Gladbach (DE)
(74) Vertreter: Herzog, Martin

(56) Entgegenhaltungen:
- EP-A- 1 227 529
- EP-A- 1 498 920
- EP-A- 1 559 739
- EP-A- 1 564 251
- EP-A- 1 647 566
- US-A1- 2004 010 115

## Beschreibung

Die Erfindung betrifft Formulierungen enthaltend Potythiophene und weitere Polymere, deren Verwendung und elektrolumineszierende Anordnungen enthaltend lochinjizierende Schichten enthaltend diese Formulierungen.

Eine elektrolumineszierende Anordnung (EL-Anordnung) ist dadurch charakterisiert, dass sie bei Anlegung einer elektrischen Spannung unter Stromfluss Licht aussendet. Derartige Anordnungen sind unter der Bezeichnung "Leuchtdioden" (LEDs = "light emitting diodes") seit langem bekannt. Die Emission von Licht kommt dadurch zustande, dass positive Ladungen (Löcher, "holes") und negative Ladungen (Elektronen, "electrons") unter Aussendung von Licht rekombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau einer EL-Anordnung ist z.B. wie folgt:
1 Träger, Substrat
2 Basiselektrode
3 Löcher-injizierende Schicht
4 Elektronen blockierende Schicht
5 Emitter-Schicht
6 Löcher blockierende Schicht
7 Elektronen-injizierende Schicht
8 Topelektrode
9 Kontakte
10 Umhüllung, Verkapselung

Dieser Aufbau stellt den detailliertesten Fall dar und kann vereinfacht werden, indem einzelne Schichten weggelassen werden, so dass eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der Emission von Licht - erfüllt.

Es hat sich aber in der Praxis gezeigt, dass zur Erhöhung der Leuchtdichte elektronen- und/oder lochinjizierende Schichten in den elektrolumineszierenden Aufbauten besonders vorteilhaft sind.

Aus der EP-A-686 662 ist bekannt, spezielle Mischungen aus leitfähigen organischen Polymeren wie Poly(3,4-ethylendioxythiophen) und beispielsweise Polyhydroxyverbindungen oder Lactamen als Elektrode in Elektrolumineszenzanzeigen einzusetzen. Es hat sich aber in der Praxis gezeigt, dass diese Elektroden besonders für großflächige Anzeigen eine nicht ausreichende Leitfähigkeit aufweisen. Für kleine Anzeigen (Leuchtfläche < 1cm²) reicht die Leitfähigkeit dagegen aus.

Aus der DE-A-196 27 071 ist bekannt, polymere organische Leiter, z.B. Poly(3,4-ethylendioxythiophen), als lochinjizerende Schichten einzusetzen. Hierdurch kann die Leuchtstärke der elektrolumineszierenden Anzeigen gegenüber Aufbauten ohne den Einsatz polymerer organischer Zwischenschichten deutlich gesteigert werden. Durch Reduzierung der Teilchengröße der Poly(3,4-alkpendioxythiophen)-Dispersionen lässt sich die Leitfähigkeit gezielt einstellen. Damit gelingt es, ein elektrisches Übersprechen benachbarter Adresslinien (crosstalk) insbesondere in Passiv-Matrix-Anzeigen zu verhindern (EP-A-1 227 529).

EP-A 1 564 251 beschreibt zudem, dass die Lebensdauer dieser Anzeigen durch Verwendung spezieller polymerer Anionen verbessert werden kann.

Allerdings ist die Leitfähigkeit der lochinjizierenden Schichten aus bekannten Materialien trotz der Möglichkeit der gezielten Einstellung über die Teilchengröße für manche Anwendungen wie beispielsweise Passiv-Matrix-Anzeigen zu hoch oder aber die Herstellung der Anzeigen aufgrund des erhöhten Aufwandes für die vorherige Reduzierung der Teilchengrößen nicht mehr wirtschaftlich genug.

Es bestand daher weiterhin Bedarf, EL-Anordnungen herzustellen, die neben einer hohen Leuchtstärke (Leuchtintensität) und einer hohen Lebensdauer eine geringere Leitfähigkeit der lochinjizierenden Schicht aufweisen als bekannte EL-Anordnungen. Beispielsweise in Passiv-Matrix-Anzeigen hätte dies den vorteilhaften Effekt der Reduktion von crosstalk, ohne dass die Verwendung von Ausgangsmaterialien mit besonders kleinen Teilchengrößen verwendet werden müssten.

Die Aufgabe der vorliegenden Erfindung bestand daher darin, geeignete Formulierungen zur Herstellung solcher EL-Anordnungen aufzufinden und bereitzustellen. Eine weitere Aufgabe bestand darin, aus diesen Materialien verbesserte EL-Anordnungen herzustellen.

Überraschend wurde gefunden, dass sich bisher unbekannte Formulierungen enthaltend spezielle gegebenenfalls substituierte Polythiophene und weitere Polymere hervorragend zur Herstellung lochinjizierender Schichten für EL-Anordnungen eignen und diese Iochinjizierenden Schichten ohne die Forderung nach besonders kleinen Teilchengrößen das Auftreten von crosstalk verhindern können.

Gegenstand der vorliegenden Erfindung sind daher Formulierungen enthaltend
A) wenigstens ein Polythiophen enthaltend wiederkehrende Einheiten der allgemeinen Formel (I-a) 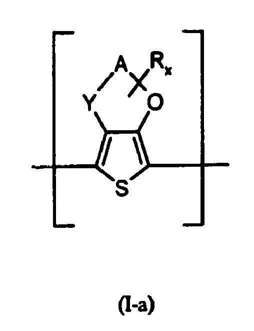 worin
   A für einen gegebenenfalls substituierten C₁-C₅-Alkylenrest, bevorzugt für einen gegebenenfalls substituierten Ethylen- oder Propylenrest, besonders bevorzugt für einen 1,2-Ethandiyl-Rest steht,
   Y unanhängig voneinander für O oder S steht,
   R für einen linearen oder verzweigten C₁-C₁₈-Alkylrest, bevorzugt für einen linearen oder verzweigten C₁-C₁₄-Alkylrest, besonders bevorzugt für einen Methyl- oder Ethylrest, einen C₅-C₁₂-Cycloalkylrest, einen C₆-C₁₄-Arylrest, einen C₇-C₁₈-Aralkylrest, einen C₁-C₄-Hydroxyalkylrest oder einen Hydroxylrest steht,
   x für eine ganze Zahl von 0 bis 8, bevorzugt für 0, 1 oder 2, besonders bevorzugt für 0 oder 1 steht und
   für den Fall, dass mehrere Reste R an A gebunden sind, diese gleich oder unterschiedlich sein können, wobei für den Fall, dass in der allgemeinen Formel (I-a) Y für O steht, das Polythiophen zudem wiederkehrende Einheiten der allgemeinen Formel (I-a), worin Y für S steht, enthält,
B) wenigstens ein SO₃⁻M^{+**-**} Gruppen enthaltendes Polymer, wobei M⁺ für H⁺, Li⁺, Na⁺, K⁺, Rb⁺, Cs⁺ oder NH₄⁺, bevorzugt für H⁺, Na⁺ oder K⁺ steht,
   wobei das SO₃⁻M⁺-Gruppen enthaltende Polymer Polystyrolsulfonsäure ist, und C) wenigstens ein SO₃⁻M⁺- oder COO⁻M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺, bevorzugt für H⁺, Na⁺ oder K⁺ steht, wobei das Gewichtsverhältnis von Polythiophen(en) A zu dem(n) Polymer(en) B von 1 zu 2 bis 1 zu 25 und das Gewichtsverhältnis von Polythiophen(en) A) zu dem(n) teilfluoriertem(n) oder perfluoriertem(n) Polymer(en) C) von 1 zu 1 bis 1 zu 50 beträgt,)

Die allgemeine Formel (I) ist so zu verstehen, dass der Substituent R x-mal an den Alkylenrest A gebunden sein kann.

Formulierung (Zusammensetzung) im Sinne der Erfindung ist jede Mischung der Komponenten A), B) und C) als Feststoff, Lösung oder Dispersion. Zusätzlich zu dem oder den Polythiophen(en) A) können auch andere bekannte leitfähige Polymere eingesetzt werden, insbesondere gegebenenfalls substituierte Polyaniline, Polypyrrole oder Polythiophene wie z.B. Homopolythiophene aus wiederkehrenden Einheiten der allgemeinen Formel (I-a), worin Y für O steht. Ein solches bevorzugtes Homopolythiophen aus wiederkehrenden Einheiten der allgemeinen Formel (I-a), worin Y für O steht, ist Poly(3,4-ethylendioxythiophen). Diese verschiedenen leitfähigen Polymere können in beliebiger Mischung mit den Polythiophenen A) eingesetzt werden.

Unter substituiert ist hier und im folgenden, wenn nicht ausdrücklich anders erwähnt, eine Substitution mit einer Gruppe ausgewählt aus der Reihe:

Alkyl, bevorzugt C₁-C₂₀-Alkyl-, Cycloalkyl-, bevorzugt C₃-C₂₀-cycloalkyl-, Aryl-, bevorzugt C₆-C₁₄-Aryl-, Halogen-, bevorzugt Cl, Br, J, Ether-, Thioether-, Disulfid-, Sulfoxid-, Sulfon-, Amino-, Aldehyd-, Keto-, Carbonsäureester-, Cyano-, Alkylsilan- und Alkoxysilangruppen sowie Carboxylamidgruppen zu verstehen.

In bevorzugten Ausfiihrungsformen der erfindungsgemäßen Formulierung ist wenigstens ein Polythiophen enthaltend wiederkehrende Einheiten der allgemeinen Formel (I-a) ein solches enthaltend wiederkehrende Einheiten der allgemeinen Formel (I-aa), 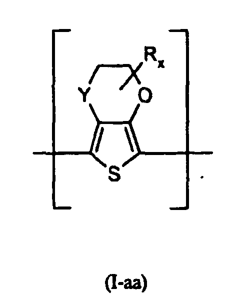 worin
R, Y und x die oben genannte Bedeutung haben.

In ganz besonders bevorzugten Formulierungen gemäß obiger Beschreibung steht x für 0 oder 1. Für den Fall, dass x gleich 1 ist, steht R besonders bevorzugt für Methyl oder Hydroxymethyl.

In weiteren bevorzugten Ausführungsformen der erfindungsgemäßen Formulierung ist wenigstens ein Polythiophen A) enthaltend wiederkehrende Einheiten der allgemeinen Formel (I-a) ein solches enthaltend wiederkehrende Einheiten der allgemeinen Formel (I-aa-1) und/oder (I-aa-2) und/oder (I-bb-1)

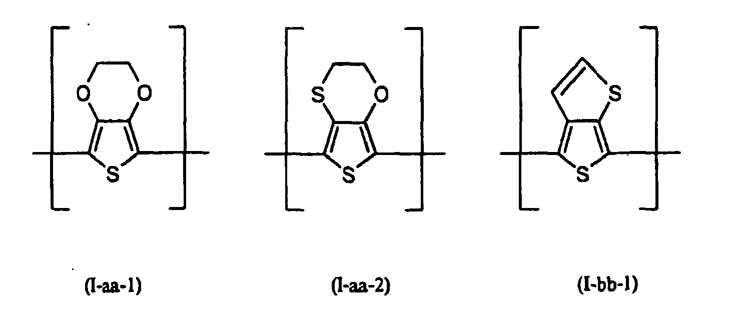

Unter dem Präfix Poly-ist im Rahmen der Erfindung zu verstehen, dass mehr als eine gleiche oder verschiedene wiederkehrende Einheit im Polymeren bzw. Polythiophen enthalten ist Die Polythiophene enthalten insgesamt n wiederkehrende Einheiten der allgemeinen Formel (I-a) wobei n eine ganze Zahl von 2 bis 2000, bevorzugt 2 bis 100, sein kann. Die wiederkehrenden Einheiten der allgemeinen Formel (I-a) können innerhalb eines Polythiophens jeweils gleich oder verschieden sein. Bevorzugt sind Polythiophene enthaltend jeweils gleiche wiederkehrende Einheiten der allgemeinen Formel (I-a), worin Y für S steht, sowie Copolymere enthaltend wiederkehrende Einheiten der allgemeinen Formel (I-a), worin Y sowohl für O als auch für S steht. Besonders bevorzugt sind dies Homopolythiophene aus wiederkehrenden Einheiten der allgemeinen Formel (I-aa), worin Y für S steht, ganz besonders bevorzugt solche Homopolythiophene aus wiederkehrenden Einheiten der Formel (I-aa-2). Weiterhin besonders bevorzugt sind Copolythiophene aus wiederkehrenden Einheiten der allgemeinen Formel (I-aa), worin Y sowohl für O als auch für S steht, ganz besonders bevorzugt solche Copolythiophene aus wiederkehrenden Einheiten der Formeln (I-aa-1) und (I-aa-2), oder aus wiederkehrenden Einheiten der Formeln (I-aa-2) und (I-bb-1).

Unter wiederkehrenden Einheiten sind im Rahmen der Erfindung Einheiten der allgemeinen Formeln (I-a), (I-b), (I-aa), (I-bb), (I-aa-1), (I-aa-2) oder (I-bb-1), im Folgenden als wiederkehrende Einheiten der allgemeinen Formel (I) zusammengefasst, zu verstehen, unabhängig davon, ob sie einmal oder mehrmals im Polythiophen enthalten sind. D.h., Einheiten der allgemeinen Formel (I) sind auch dann als wiederkehrende Einheiten zu verstehen, wenn sie nur einmal im Polythiophen enthalten sind.

Erfindungsgemäße Formulierungen können auch solche sein, die neben wenigstens einem der vorangehend beschriebenen Polythiophene A) enthaltend wiederkehrende Einheiten der allgemeinen Formel (I) in der Mischung weitere leitfähige Polymere, wie Polyaniline, Polypyrrole oder sonstige Polythiophene enthalten. In bevorzugten Ausfiihrungsformen können die erfindungsgemäßen Formulierungen neben den vorangehend beschriebenen Polythiophenen A), enthaltend wiederkehrende Einheiten der allgemeinen Formel (I), (I-a) in der Mischung Poly(3,4-ethylendioxythiophen) als sonstiges Polythiophen enthalten.

An den Endgruppen tragen die Polythiophene bevorzugt jeweils H.

Die Polythiophene A) enthalten insgesamt n wiederkehrende Einheiten der allgemeinen Formel (I-a); wobei n bevorzugt eine ganze Zahl von 2 bis 1000, bevorzugt 3 bis 100, besonders bevorzugt 4 bis 15 ist.

C₁-C₅-Alkyenreste A sind insbesondere Methylen, Ethylen, n-Propylen, n-Butylen oder n-Pentylen. C₁-C₁₈-Alkyl steht insbesondere für lineare oder verzweigte C₁-C₁₈-Alkylreste, beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste wie beispielsweise Cyclopentyl, Cyclohexyl, Cycloheptyl, Cyclooctyl, Cyclononyl oder Cyclodecyl, C₆-C₁₄-Aryl für C₆-C₁₄-Arylreste, beispielsweise Phenyl oder Naphthyl, C₇-C₁₈-Aralkyl für C₇-C₁₈-Aralkylreste, beispielsweise Benzyl, und C₇-C₁₈-Alkylaryl für C₇-C₁₈- Alkylarylreste, beispielsweise o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Die Herstellung der vorangehend beschriebenen Polythiophene A) enthaltend wiederkehrende Einheiten der allgemeinen Formel (I) (I-a) ist prinzipiell in EP-A 440 957, in Blanchard, Philippe; Cappon, Alexandre; Levillain, Eric; Nicolas, Yohann; Frere, Pierre; Roncali, Jean, Organic Letters (2002), 4(4), 607-609, bzw. in Lee, Byoungchul; Seshadri, Venkatara-manan; Sotzing, Gregory A., Synthetic Metals (2005), 152(1-3), 177-180 beschrieben.

Die Polymerisation der entsprechenden monomeren Ausgengsverbindungen wird mit geeigneten Oxidationsmitteln in geeigneten Lösungsmitteln durchgeführt. Beispiele für geeignete Oxidationsmittel sind Eisen(III)-salze, insbesondere FeCl₃ und Eisen(III)-salze aromatischer und aliphatischer Sulfonsäuren, H₂O₂, K₂Cr₂O₇, K₂S₂O₈, Na₂S₂O₈, KMnO₄, Alkaliperborate und Alkali- oder Ammoniumpersulfate oder Mischungen dieser Oxidationsmittel. Weitere geeignete Oxidationsmittel sind beispielsweise in Handbook of Conducting Polymers (Ed. Skotheim, T.A.), Marcel Dekker: New York, 1988, Vol. 1, 46-57 beschrieben. Besonders bevorzugte Oxidationsmittel sind FeCl₃, Na₂S₂O₈₁ und K₂S₂O₈ oder Mischungen hiervon. Die Polymerisation wird bevorzugt bei einer Reaktionstemperatur von -20 bis 100°C durchgeführt Besonders bevorzugt sind Reaktionstemperaturen von 20 bis 100°C. Gegebenenfalls wird die Reaktionslösung anschließend mit wenigstens einem Ionenaustauscher behandelt

Geeignete Lösungsmittel für die vorgenannte Reaktion sind z.B. polare Lösungsmittel, beispielsweise Wasser, Alkohole wie Methanol, Ethanol, 2-Propanol, n-Propanol, n-Butanol, Diacetonalkohol, Ethylenglykol, Glycerin oder Mischungen aus diesen. Ebenfalls geeignet sind aliphatische Ketone wie Aceton und Methylethylketon, aliphatische Nitrile wie Acetonitril, aliphatische und cyclische Amide wie N,N-Dimethylacetamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen aus diesen untereinander oder mit den vorangehend aufgeführten Lösungsmitteln.

Die entsprechenden monomeren Verbindungen zur Herstellung von Polythiophenen A) enthaltend wiederkehrende Einheiten der allgemeinen Formel (I-a) sind bekennt Ihre Herstellung ist beispielsweise durch Umsetzung der Alkalisalze der 3,4-Dihydroxythiophen-2,5-dicarbonsäureester mit den entsprechenden Alkylen-dihalogeniden und nachfolgende Decarboxylierung der freien 3,4-(Alkylendioxy)thiophen-2,5-dicarbonsäuren (siehe z. B. Tetrahedron 1967, 23, 2437 - 2441 und J. Am. Chem. Soc. 1945, 67, 2217 - 2218), durch Umetherung von 3,4-Dialkoxythiophenen mit 2-Mercapto-ethanol (Blanchard, Philippe; Cappon, Alexandre; Levillain, Eric; Nicolas, Yohann; Frere, Pierre; Roncali, Jean, Organic Letters (2002), 4(4), 607-609), bzw. im Falle des Thieno(3,4-b)thiophens gemäß L. Brandsma, H. D. Verkrujisse, Synth. Commun. 20 (1990) 2275 möglich.

Die resultierenden Polythiophene sind sehr gut in den polaren Lösungsmitteln oder Lösungsmittelgemischen
löslich oder dispergierbar.

Die erfindungsgemäßen Formulierungen enthalten neben wenigstens einem teilfluorierten bzw. perfluorierten Polymer C) wenigstens ein weiteres SO₃⁻M⁺-Gruppen enthaltendes Polymer B), bei dem es sich um Polystyrolsulfonsäure handelt.

Bevorzugt sind diese Polymere B) in polaren Lösungsmitteln wie Wasser, Alkoholen wie Methanol, Ethanol, 2-Propanol, n-Propanol, n-Butanol, Diacetonalkohol, Ethylenglykol, Glycerin, aliphatischen Ketonen wie Aceton und Methylethylketon, aliphatischen Nitrilen wie Acetonitril, aliphatischen und cyclischen Amiden wie N,N-Dimethylacetamid, N,N-Dimethylformamid (DMF) und 1-Methyl-2-pyrrolidon (NMP), Ethern wie Tetrahydrofuran (THF) sowie Sulfoxiden wie Dimethylsulfoxid (DMSO) oder Mischungen enthaltend diese, bevorzugt in Wasser, Alkoholen wie Methanol, Ethanol, 2-Propanol, n-Propanol und n-Butanol oder Mischungen aus diesen löslich oder dispergierbar.

Besonders geeignete Formulierungen gemäß obiger Beschreibung sind dadurch gekennzeichnet, dass sie als wenigstens ein SO₃⁻M⁺⁻ oder COO⁻M⁺-Gruppen enthaltendes teilfluoriertes oder perfluoriertes Polymer C) beispielsweise solche enthaltend wiederkehrende Einheiten der Formeln (II-a) und (II-b), 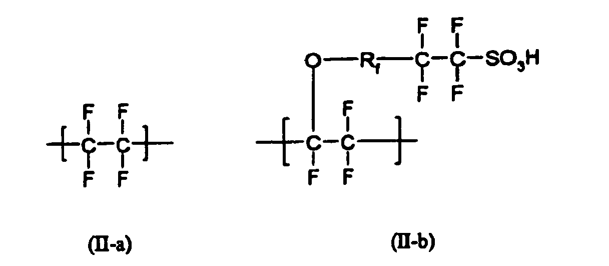 worin R₁ für einen Rest mit wenigstens einer, bevorzugt 1 bis 30 wiederkehrenden Einheit(en) der Formel (II-c) 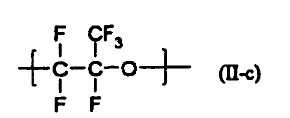 steht, enthalten. Solche perfluorierten Polymere sind beispielsweise die kommerziell unter dem Handelsnamen Nafion^{®} oder In gelöster Form unter dem Haendelsnamen Liquion^{®} erhältlichen Polymere.

In besonders bevorzugten Ausführungsformen enthält die neue Formulierung als wenigstens ein SO₃-M⁺- oder COOM⁺-Gruppen enthaltendes Polymer C) Nafion^{®} (Copolymer aus Tetrafluorethylen und dem Trifluorvinylether des Poly(hexafluorpropylenoxid)mono(tetrafluorvinylsulfonsäure)-ethers).

Besonders bevorzugt werden Formulierungen, die als SO₃-M⁺- oder COO-M⁺-Gruppen enthaltendes Polymer B) Polystyrolsulfonsäure (PSS) und als SO₃⁻M⁺- oder COO⁻M⁺-Gruppen enthaltendes teilfluoriertes oder perfluoriertes Polymer C) Nafion^{®} (Copolymer aus Tetrafluorethylen und dem Trifluorvinylether des Poly(hexafluorpropylenoxid)mono (tetrafluorvinylsulfonsäure)-ethers) enthalten.

Das Molekulargewicht der Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Ganz besonders bevorzugt sind Formulierungen, bei denen das Gewichtsverhältnis von Polythiophen(en) A) gegebenenfalls zuzüglich enthaltenem zusätzlichem leitfähigem Polymer zu SO₃⁻M⁺- Gruppen enthaltendem(n) Polymer(en) B) von 1 zu 2 (1:2) bis 1 zu 25 (1:25), bevorzugt von 1 zu 2 (1:2) bis 1 zu 20 (1:20) beträgt.

Weiterhin ganz besonders bevorzugt sind Formulierungen bei denen das Gewichtsverhältnis von Polythiophen (en) A) gegebenenfalls zuzüglich enthaltenem zusätzlichem leitfähigem Polymer zu SO₃⁻ M⁺- oder COO⁻M⁺-Gruppen enthaltendem(n), teilfluoriertem(n) oder perfluoriertem(n) Polymer(en) C) von 1 zu 1 (1:1) bis 1 zu 50 (1:50), bevorzugt von 1 zu 2 (1:2) bis 1 zu 30 (1:30) beträgt.

Alle beliebigen Kombinationen der beiden vorangehend beschriebenen Gewichtsverhältnisse von Polythiophen (en) A) zu SO₃-M⁺- Gruppen enthaltendem(n) Polymer(en) B) und Polythiophen(en) A) zu SO₃⁻M⁺- oder COO-M⁺-Gruppen enthaltendem(n), teilfiuoriertem(n) oder perfluoriertem(n) Polymer(en) C) können In den bevorzugten Formulierungen realisiert sein und gelten hiermit als offenbart.

Weiterhin können die neuen Formulierungen zusätzlich wenigstens ein polares Verdünnungsmittel D) (polares Lösungsmittel) enthalten. Unter polaren Verdünnungsmitteln D) (polaren Lösungsmitteln) sind im Rahmen der Erfindung Verdünnungsmittel mit einem Löslichkeilsperameter δ von 16 MPa^{½} und größer, bevorzugt 19 MPa^{½} und größer zu verstehen. Die Messung von Löslichkeitsparametern findet in der Regel bei Standardtemperatur (20°C) statt. Zur Messung und Berechnung von Löslichkeitsparametern siehe J. Brandrup et al., Polymer Handbook, 4th Ed., 1999, VII/675 - VII/688. Löslichkeitsparameter sind tabelliert, z.B. in J. Brandrup et al., Polymer Handbook, 4th Ed., 1999, VII/688 - VII/697. Bevorzugte polare Verdünnungsmittel D) sind Wasser, Alkohole wie Methanol, Ethanol, 2-Propanol, n-Propanol, n-Butanol, Diacetonalkohol, Ethylenglykol, Glycerin, aliphatische Ketone wie Aceton und Methylethylketon, aliphatische Nitrile wie Acetonitril, aliphatische und cyclische Amide wie N,N-Dimethylacetamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen enthaltend diese. Besonders bevorzugte polare Verdünnungsmittel D) sind Wasser, Alkohole oder Mischungen enthaltend diese, ganz besonders bevorzugt sind Wasser, Methanol, Ethanol, n-Propanol, 2-Propanol oder n-Butanol oder Mischungen enthaltend diese. In bevorzugten Ausführungsformen enthalten die neuen Formulierungen als polares Verdünnungsmittel D) Mischungen aus Wasser und wenigstens einem Alkohol.

Solche neuen bevorzugten Formulierungen enthaltend wenigstens ein polares Verdünnungsmittel D) enthalten bevorzugt 99.99 bis 80 Gew.-%, besonders bevorzugt 99,8 bis 95 Gew.-% polare(s) Verdünnungsmittel und weisen einen Feststoffgehalt von 0,01 bis 20 Gew.-%, besonders bevorzugt 0,2 bis 5 Gew.-% auf, d.h. enthalten insgesamt 0,01 bis 20 Gew.-%, besonders bevorzugt 0,2 bis 5 Gew.-% Polythiophen(e) A), SO₃-M⁺- Gruppen enthaltende(s) Polymer(e) B) und C) und gegebenenfalls weitere enthaltene Komponenten, wie z.B. Bindemittel, Vemetzungsmittel und/oder Tenside, in gelöster und/oder dispergierter Form.

Die Viskosität bei 20°C von neuen bevorzugten Formulierungen enthaltend wenigstens ein polares Verdünnungsmittel liegt zwischen der Viskosität des Verdünnungsmittels und 200 mPas, bevorzugt < 100 mPas.

Zur Einstellung des gewünschten Feststoffgehaltes und der erforderlichen Viskosität kann aus den Formulierungen die gewünschte Menge Verdünnungsmittel durch Destillation, bevorzugt im Vakuum, oder durch andere Verfahren, z.B. Ultrafiltration, entfernt werden.

Den erfindungsgemäßen Formulierungen können außerdem organische, polymere Bindemittel und/oder organische, niedermolekulare Vernetzungsmittel oder Tenside zugesetzt werden. Entsprechende Bindemittel sind z.B. in EP-A-564 911 beschrieben. Beispielhaft seien hier Polyvinylcarbazol als Bindemittel, Silane, wie Silquest^{®} A187 (Fa. OSI specialities) oder Tenside als Vernetzungsmittel, wie das Fluortensid FT 248 (Bayer AG) aufgeführt.

Die Formulierungen können bevorzugt geringe Mengen ionischer Verunreinigungen in den Grenzen wie sie in EP-A-991 303 beschrieben sind, enthalten. Bevorzugt enthalten die Formulierungen weniger als 1000 ppm ionischer Verunreinigungen.

Die erfindungsgemäßen Formulierungen können auf einfache Weise hergestellt werden, indem eine bereits fertige Mischung enthaltend wenigstens ein SO₃-M⁺- Gruppen enthaltendes Polymer B) und wenigstens ein Polythiophen A) in einem für die erfindungsgemäßen Formulierungen vorangehend angegebenem Gewichtsverhältnis, welche gegebenenfalls in Form einer Lösung oder Dispersion vorliegen, mit wenigstens einem teilfluorierten oder perfluorierten, SO₃⁻M⁺- oder COO⁻M⁺-Gruppen enthaltenden Polymer C) in einem für die erfindungsgemäßen Formulierungen vorangehend angegebenem Gewichtsverhältnis zum Polythiophen A), welches gegebenenfalls in Form einer Lösung oder Dispersion vorliegt, gemischt wird. Dieses Verfahren zur Herstellung der erfindungsgemäßen Formulierungen ist ebenfalls Gegenstand der vorliegenden Erfindung. Beispielsweise ist es möglich, eine bereits fertige Mischung enthaltend wenigstens ein SO₃⁻M⁺- Gruppen enthaltendes Polymer B) und wenigstens ein Polythiophen A) mit wenigstens einem teilfluorierten oder perfluorierten, SO₃⁻M⁺- oder COO⁻M⁺-Gruppen enthaltenden Polymer C) zu mischen und dieses Gemisch gegebenenfalls mit wenigstens einem Verdünnungsmittel zu versetzen, bevorzugt in wenigstens einem Verdunnungsmittel ganz oder teilweise zu lösen oder zu dispergieren. Es ist auch möglich, wenigstens eine bereits fertige Mischung enthaltend ein S03 M⁺- Gruppen enthaltendes Polymer B) und wenigstens ein Polythiophen A) vorab mit wenigstens einem Verdünnungsmittel D) zu versetzen, bevorzugt in wenigstens einem Verdünnungsmittel D) ganz oder teilweise zu lösen oder zu dispergieren, wenigstens ein SO₃-M⁺- oder COO-M⁺-Gruppen enthaltendes teilfluoriertes oder perfluoriertes Polymer C) in einem Verdünnungsmittel zu lösen oder zu dispergieren und die Lösung(en) und/oder Dispersion(en) anschließend zu mischen. Gegebenenfalls kann aus dieser Mischung anschließend das Verdunnungsmittel D) oder Verdünnungsmtttelgemisch ganz oder teilweise wieder entfernt werden, z.B. durch Destillation oder andere Verfahren.

Überraschend eignen sich die erfindungsgemäßen Formulierungen hervorragend für die Herstellung lochinkjizierender oder lochtransportierender Schichten in EL-Anordnungen, organischen Solarzellen, organischen Laserdioden, organischen Dünnfilmtransistoren oder organischen Feldeffekttrensistoren, zur Herstellung von Elektroden oder elektrisch leitfähiger Beschichtungen.

Daher ist ebenfalls Gegenstand der vorliegenden Erfindung die Verwendung der erfindungsgemäßen Formulierungen zur Herstellung lochinjizierender Schichten in EL-Anordnungen, zur Herstellung von Elektroden oder elektrisch leitfähiger Beschichtungen.

Diese EL-Anordnungen findet Verwendung als Anzeigeelemente ("Displays"), z. B. in Flach-Bildschirmen wie Laptop, Pager, Mobiltelefon, Navigationsgeräte, Auto-Radios, Kfz-Instrumententafeln, oder als Flächenstrahler, z.B. Lampen, Leuchtflächen, Hintergrundbeleuchtung für LCD-Displays, Schilder.

Insbesondere EL-Anordnungen mit einer lochinjizierenden Schicht enthaltend eine erfindungsgemäße Formulierung zeichnen sich durch eine hohe Leuchtstärke (Leuchtintensität) und Lebensdauer aus, bieten jedoch gegenüber bekannten EL-Anordnungen den Vorteil, dass eine aufwändige Kontrolle der Teilchengröße zur Vermeidung von beispielsweise crosstalk in Passiv-Matrix-Anzeigen nicht erforderlich ist.

Unter "crosstalk versteht der Fachmann das elektrische Übersprechen zwischen benachbarten Adresslinien in Passiv-Matrix-Anzeigen. Um crosstalk in OLEDs zu vermeiden, ist es notwendig, dass keine der verwendeten Schichten einen elektrischen spezifischen Widerstand von unter 1 E4 Ohm-cm hat. Insbesondere für die lochinjizierende Schicht besteht die Forderung den elektrischen Widerstand im Bereich von 1·10⁴ Ohm-cm bis 1·10⁷ Ohm cm zu halten. Die obere Grenze ergibt sich aus der Notwendigkeit den Spannungsabfall über die Schicht auf ein Mindestmaß zu limitieren. Der spezifische Widerstand wird aus dem Produkt von Oberflächenwiderstand und Schichtdicke der leitfähigen Polymerschicht errechnet. Der Oberflächenwiderstand wird für leitfähige Polymere entsprechend der DIN EN ISO 3915, die Dicke der Polymerschicht wird mit Hilfe eines Stylus-Profilometers gemessen.

Einen weiteren Vorteil bietet die erfindungsgemäße Formulierung bezüglich des erreichten elektrischen Gleichrichtungsverhättnisses in EL-Anordnungen. Darunter versteht der Fachmann das Verhältnis des Stroms in Durchlassrichtung zu dem in Sperrrichtung bei einer festen Spannung. Wird eine OLED in Durchgangsrichtung gepolt, d.h. die Anode, z.B. ITO-Anode, wird mit dem positiven Pol der Spannungsquelle verbunden und die aufgedampfte Metallelektrode mit dem negativen Pol, so fließt ein Durchlassstrom "I+". Bei umgekehrter Polung fließt ein Sperrstrom "I-". Da während des Betriebs von Passiv-Matrix-OLEDs die überwiegende Anzahl der einzelnen Leuchtpunkte (Pixel) in Sperrrichtung gepolt sind, ist ein möglichst hohes Gleichrichtungsverhältnis wünschenswert, um die elektrischen Verluste niedrig zu halten. Empfohlen werden Gleichrichtungsverhältnisse von I+/I- > 1·-10⁵.

Ebenfalls Gegenstand der vorliegenden Erfindung sind daher EL-Anordnungen insbesondere Leuchtdioden enthaltend eine lochinjizierende Schicht enthaltend eine erfindungsgemäße Formulierung. Bevorzugt sind dies solche EL-Anordnungen enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierenden Schicht zwischen einer der beiden Elektroden und der Emitter-Schicht, dadurch gekennzeichnet, dass die lochinjizierende Schicht eine erfindungsgemäße Formulierung enthält.

Bei der Herstellung von vielen großflächigen EL-Anordnungen, z.B. großflächigen elektrolumineszierenden Anzeigeelementen, ist es vorteilhaft, wenn mindestens eine der stromzuführenden Elektroden aus einem transparenten und leitfähigem Material besteht. Als solche transparenten und leitfähigen Elektroden-Materialien sind beispielsweise
a) Metalloxide, z.B. Indium-Zinn-Oxid (ITO), Zinnoxid (NESA), dotiertes Zinnoxid, dotiertes Zinkoxid etc.,
b) semi-transparente Metallfilme, z.B. Au, Pt, Ag, Cu etc.,
c) semi-transparente, leitfähige Polymere, z.B. Polythiophene, Polyaniline, Polypyrrole etc. geeignet.

Bei einer Elektrode, die nicht aus einem der vorangehend aufgeführten transparenten und leitfähigen Materialien besteht, handelt es sich vorzugsweise um eine Metallelektrode, insbesondere um eine Metallkathode.

Geeignete Materialien für Metallkathoden sind die für elektrooptische Aufbauten gängigen Materialien und dem Fachmann bekannt. Als Metallkathode kommen bevorzugt solche aus Metallen mit geringer Austrittsarbeit wie Mg, Ca, Ba oder Metallsalzen wie UF in Betracht.

Als gegebenenfalls transparentes Substrat eignet sich beispielsweise Glas, Dünnstglas (flexibles Glas) oder Kunststoffe, bevorzugt Kunststofffolien.

Besonders geeignete Kunststoffe für das Substrat sind: Polycarbonate, Polyester wie z.B. PET und PEN (Polyethylenterephthalat bzw. Polyethylennaphthalindicarboxylat), Copolycarbonate, Polyacrylat, Polysulfon, Polyethersulfon (PES), Polyimid. Polyethylen, Polypropylen oder cyclische Polyolefine bzw. cyclische Olefincopolymere (COC), hydrierte Styrolpolymere oder hydrierte Styrolcopolymere.

Geeignete Polymeninterlagen können beispielsweise Folien wie Polyesterfolien, PES-Folien der Firma Sumitomo oder Polycarbonaftolien der Firma Bayer AG (Makrofol^{®}) sein.

In der Emitter-Schicht der erfindungsgemäßen EL-Anordnung ist wenigstens ein Emittermaterial enthalten. Geeignete Emlttermaterlalien sind die für elektrooptische Aufbauten gängigen und dem Fachmann bekannt. Als Emittermaterialien kommen bevorzugt konjugierte Polymere wie Polyphenylenvinylene und/oder Polyfluorene, wie die beispielsweise in WO-A 90/13148 beschriebenen Polyparaphenylenvinylenderivate und Polyfluorenderivate, oder Emitter aus der Klasse der niedermolekularen Emitter, in Fachkreisen auch als "small molecules" bezeichnet, wie Aluminiumkomplexe, z.B. Tris(8-hydroxychinolinato)aluminium (Alq₃), Fluoreszenzfarbstoffe, z.B. Chinacridone, oder phosphoreszierende Emitter, z.B. Ir(ppy)_{3'} in Betracht. Emittermaterialien sind z.B. in DE-A 196 27 071 beschrieben.

Zusätzlich zu den vorangehend aufgeführten Schichten können weitere funktionelle Schichten in einem solchen elektrolumineszierenden Schichtaufbau (EL-Anordnung) enthalten sein, wie z.B. weitere ladungsinjizierende, z.B. elektroneninjizierende, ladungstransportierende oder ladungsblockierende Zwischenschichten. Solche Schichtaufbauten sind dem Fachmann bekannt und beispielsweise in J.R. Sheats et al., Science 273, (1996), 884 beschrieben. Eine Schicht kann auch mehrere Aufgaben übernehmen. Beispielsweise können die vorangehend aufgeführten Emittermaterialien in Kombination mit einer lochtrensportierenden Zwischenschicht zwichen lochinjizierender und Emitter-Schicht eingesetzt werden (vgl. z.B. US 4,539,507 und US 5,150,006).

Die prinzipielle Herstellung solcher EL-Anordnungen ist dem Fachmann bekannt. Sie können beispielsweise so hergestellt werden, dass eine Elektrode aus Lösung oder Dispersion oder durch Aufdampfen auf ein Substrat aufgebracht wird. Z.B. werden Metalloxid- oder semi-transparente Metallfilmelektroden bevorzugt durch Aufdampfen, semi-transparente, leitfähige Polymerelektroden hingegen bevorzugt aus Lösung oder Dispersion auf das Substrat aufgebracht. Gegebenenfalls kann vor Aufbringen des Elektrodenmaterials auf das Substrat ein Haftvermittler - durch Aufdampfen oder aus Lösung oder Dispersion - aufgebracht werden. Einige solcher mit Elektrodenmaterial beschichteten Substrate sind auch bereits kommerziell erhältlich (z.B. K-Glas, ITO-beschichtete Glassubstrate). Auf die Elektrode kann anschließend die lochinjizlerende Schicht aufgebracht werden, was bei den erfindungsgemäßen EL-Anordnungen mit lochinjizierender Schicht enthaltend eine erfindungsgemäße Formulierung vorteilhafterweise aus Lösung oder Dispersion erfolgt. Auf die lochinjizierende Schicht werden anschließend die weiteren Schichten in der einleitend aufgeführten Reihenfolge - unter Berücksichtigung, dass einzelne Schichten weggelassen werden können - je nach eingesetztem Material aus Lösung oder Dispersion oder durch Aufdampfen aufgebracht. Anschließend wird die Schichtanordnung kontaktiert und gekapselt.

Die Herstellung der lochinjizierenden Schicht enthaltend eine erfindungsgemäße Formulierung erfolgt nach bekannten Technologien. Dazu wird eine erfindungsgemäße Formulierung - gegebenenfalls in einem Lösungsmittel - auf einer Elektrode, bevorzugt der Basiselektrode, als Film aufgetragen. Als Lösungsmittel eignen sich die oben aufgeführten polaren Verdünnungsmittel, bevorzugt Wasser, Alkohole oder Mischungen aus diesen. Geeignete Alkohole sind z.B. Methanol, Ethanol, n-Propanol, 2-Propanol und n-Butanol.

Die Verwendung dieser Lösungsmittel hat den Vorteil, dass weitere Schichten aus organischen Lösungsmitteln, wie aromatischen oder aliphatischen Kohlenwasserstoffgemischen aufgebracht werden können, ohne dass die lochinjizierende Schicht angegriffen oder wieder aufgelöst wird.

Die erfindungsgemäße Formulierung - gegebenenfalls in einem Lösungsmittel - kann beispielsweise durch Drucktechniken wie Spincoaten, Casting, Rakeln, Drucken, Vorhanggießen etc. auf der Elektrode gleichmäßig verteilt werden. Anschließend können die Schichten bei Raumtemperatur oder Temperaturen bis 300°C, bevorzugt 100 bis 200°C getrocknet werden.

Die erfindungsgemäße Formulierung - gegebenenfalls in einem Lösungsmittel - kann außerdem bevorzugt durch Techniken wie Ink-Jet strukturiert aufgebracht werden. Diese Technik ist dem Fachmann bekannt und unter Einsatz wasserlöslicher und dispergierter Polythiophene wie 3,4-Polyethylendioxytlüophen:Polystyrolsulfonsäure (PEDT:PSS) z.B. in Science, Vol. 279, 1135, 1998 und DE-A 198 41 804 beschrieben.

Vorzugsweise werden die erfindungsgemäßen Formulierungen - gegebenenfalls in einem Lösungsmittel - vor der Applizierung durch ein Filter filtriert.

Besonders gut zum Reinigen filtrierbare Formulierungen werden beispielsweise erhalten, wenn in Lösungsmittel D) bezogen auf ein Gewichtsteil Polythiophen(e) enthaltend wiederkehrende Einheiten der allgemeinen Formel (I-a) bevorzugt 1 bis 30 Gewichtsteile, besonders bevorzugt 2 bis 25 Gewichtsteile des oder der SO₃- M⁺ Gruppen enthaltende(n) Polymer(e) B) verwendet werden.

Die Dicke der lochinjizierenden Schicht beträgt beispielsweise 3 bis 500 nm, bevorzugt 10 bis 200 nm.

### Beispiele

### Beispiel 1

### Herstellung des Poly(ethylenoxythiathiophen)-PSS-Komplexes und seiner Mischung mit Nafion^{®}

Eine Lösung von 1,06 g PSS (Molekulargewicht M_{w} = 48000), 0,47 g EOTT und 0,25 g Natriumiodat in 103,7 g Wasser wurde 7 d bei 50 °C gerührt. Danach wurde die tiefblaue Reaktionsmischung mit je 9 g Kationen- und Anionenaustauscher (Lewatit^{®} S 100 und Lewatit^{®} MP 62) 8 h entionisiert und anschließend das Ionenaustauscher-Harz abfiltriert. Ionengehalte: 1 ppm Sulfat, 14 ppm Na⁺, < 20 ppm Iodid.

Die entstandene entionisierte Zubereitung wurde zur Herstellung der erfindungsgemäßen Mischung folgendermaßen abgemischt:
19,6 g obiger, entionisierter Zubereitung entsprechend 0,225 g PEOTT-PSS-Komplex
12,97 g Wasser
12,1 g Ethanol
10,75 g Liquion^{®} 1100 (Nafion^{®} enthaltende Lösung der Fa. Ion Power Inc., .US; 5 gew.%ige Lösung in 2-Propanol/H₂O, 1100 Äqu.), entsprechend 0,5 g Nafion^{®}.
Dabei wurde zunächst Ethanol und Wasser zum Liquion^{®} 1100 zudosiert, ¼ h bei 23 °C gerührt und anschließend der PEOTT-PSS-Komplex zudosiert, wonach eine weiteres ½ h bei 23 °C gerührt wurde.

Das Gewichtsverhältnis Monomer : PSS : Fluorpolymer entspricht 1: 2,3 : 7,3

### Beispiel 2

### Herstellung einer Mischung aus Poly(3,4-ethylendioxythiophen)Polystyrolsulfonsäure und einem perfluorier-ten Polymer.

Polyethylendioxythiophen/Polystyrolsulfonsäure-Lösung (H.C.Starck GmbH, Baytron^{®} PH entsalzt) wurde mit Nafion^{®}-Lösung (Liquion^{®}1100, 5 gew.%ige Lösung in 2-Propanol/H₂O, 1100 Äqu., Ion Power Inc., US) in einem Gewichtsverhältnis von PEDT : PSS : Nafion^{®} von 1 : 2,5 : 7,5 gemischt.

### Beispiel 3

Die erfindungsgemäße Formulierung aus Beispiel 1 wurde zum Aufbau einer organischen Leuchtdiode (OLED) genutzt. Bei der Herstellung der OLED wurde folgendermaßen vorgegangen:

### 1. Vorbereitung des ITO-beschichteten Substrats

ITO-beschichtetes Glas (Merck Balzers AG, FL, Part. No. 253 674 XO) wurde in 50 mm x 50 mmgroße Stücke (Substrate) geschnitten. Die Substrate wurden anschließend in 3 %iger wässriger Mukasollösung im Ultraschallbad 15 min lang gereinigt. Danach wurden die Substrate mit destilliertem Wasser gespült und in einer Zentrifuge trocken geschleudert. Dieser Spül- und Trockenvorgang wurde 10 mal wiederholt. Unmittelbar vor der Beschichtung wurden die ITO-beschichteten Seiten in einem UV/Ozon-Reaktor (PR-100, UVP Inc., Cambridge, GB) für 10 min gereinigt.

### 2. Aufbringen der lochinjizierenden Schicht

Etwa 10 ml der erfindungsgemäßen Formulierung aus Beispiel 1 wurden filtriert (Millipore HV, 0,45 µm). Das gereinigte ITO-beschichtete Substrat wurde auf eine Lackschleuder gelegt und die filtrierte Lösung auf der ITO-beschichteten Seite des Substrats verteilt. Anschließend wurde die überstehende Lösung durch Rotation des Tellers bei 500 U/min mit geschlossenem Deckel über den Zeitraum von 30 s abgeschleudert. Danach wurde das so beschichtete Substrat 5 min lang bei 200 °C auf einer Heizplatte getrocknet. Die Schichtdicke betrug 50 nm (Tencor, Alphastep 500).

An separaten Schichten wurde die Leitfähigkeit bestimmt, indem über eine Schattenmaske Ag-Elektroden mit 2,5 cm Länge in einem Abstand von 0,5 mm aufgedampft wurden (analog Prozessschritt 4). Der mit einem Elektrometer bestimmte Oberflächenwiderstandwurde mit der Schichtdicke multipliziert, um den elektrischen spezifischen Widerstand zu erhalten.

### 3. Aufbringen der Emitterschicht

5 ml einer 1 Gew.-% Xylol-Lösung des Emitters Green 1300 LUMATION™ (Dow Chemical Company) wurden filtriert (Millipore HV, 0,45 µm) und auf der getrockneten lochinjizierenden Schicht verteilt. Anschließend wurde die überstehende Lösung des Emitters durch Rotation des Tellers bei 500 U/min mit geschlossenem Deckel 30 s lang abgeschleudert. Danach wurde die Schicht auf einer Heizplatte bei 110°C für 5 min getrocknet. Die Gesamtschichtdicke betrug 130 nm.

Alle weiteren Prozessschritte wurden in reiner N₂-Atmosphäre durchgeführt (Inertgas-Gloveboxsystem, M.Braun, Garching) in die das beschichtete Substrat transferiert wurde. Zunächst wurde hier das beschichtete Substrat 15 min lang bei 130 °C auf einer Heizplatte getrocknet.

### 4. Aufbringen der Metallkathode

Auf die Emitterschicht wurde eine Metallelektrode als Kathode gedampft. Dazu wurde das Substrat mit der Emitterschicht nach unten auf eine Schattenmaske gelegt, die Löcher mit 2,5 mm Durchmesser enthielt. Aus zwei Aufdampfschiffchen wurden bei einem Druck von p=10⁻³ Pa nacheinander eine 5 nm dicke Ba-Schicht und anschließend eine 200 nm dicke Ag-Schicht aufgedampft. Die Aufdampfraten betrugen 10 Å/s für Ba und 20 Å/s für Ag. Die isolierten Metallelektroden hatten eine Fläche von 4,9 mm².

### 5. Charakterisierung der OLED

Die beiden Elektroden der organischen LED wurden über elektrische Zuführungen mit einer Spannungsquelle verbunden (kontaktiert). Der positive Pol war mit der ITO-Elektrode, der negative Pol über einen dünnen flexiblen Au-Draht mit der Metall-Elektrode verbunden. Die Abhängigkeit des OLED-Stroms und der Eiektrolumineszenzintensität (der Nachweis erfolgte mit einer Photodiode (EG&G C30809E)) von der Spannung wurden aufgezeichnet. Anschließend wurde die Lebensdauer bestimmt, indem ein konstanter Strom von I = 0.32 mA (8 mA/cm²) durch die Anordnung floss, und die Spannung und Lichtintensität zeitabhängig verfolgt wurden.

### Vergleichsbeisplel 3.1

Herstellung einer OLED mit einer Mischung aus Poly(3,4-ethylendioxythiophen)/Polystyrolsulfonsäure und Nafion^{®} als lochinjizierender Schicht:
Die Durchführung erfolgte wie in Beispiel 3, mit folgender Abweichung bei Prozessschritt 2.:

### 2. Aufbringen der lochinjizierenden Schicht

Etwa 10 ml der Lösung aus Beispiel 2 wurden filtriert (Millipore HV, 0,45 µm). Das ITO-beschichtete Substrat wurde anschließend auf eine Lackschleuder gelegt und die filtrierte Lösung auf der ITO-beschichteten Seite des Substrats verteilt. Anschließend wurde die überstehende Lösung durch Rotation des Tellers bei 850 U/min mit geschlossenem Deckel über den Zeitraum von 30 s abgeschleudert. Danach wurde das so beschichtete Substrat 5 min lang bei 200 °C auf einer Heizplatte getrocknet. Die Schichtdicke betrug 50 nm.

Das Aufbringen der Metallkathoden gemäß Prozessschritt 4 erfolgte gemeinsam mit den Schichtaufbauten aus Beispiel 3, um Vergleichbarkeit zu gewährleisten. Die Charakterisierung erfolgte ebenfalls wie in Beispiel 3.

**Tab. 1: Ergebnisse der Kennlinienmessungen der Anordnungen aus Beispiel 3 und Vergleichsbeispiel 3.1**

| | Spez. Widerstand [Ohm·cm] | Effizienz Bei U=4V [cd/A] | Gleichrichtungs-verhältnis I+/I-bei U = 8V |
|---|---|---|---|
| OLED aus Beispiel 3 | > 1·10⁶ | 6,7 | 2,2·10⁶ |
| OLED aus Vergleichsbeispiel 3.1 | 15 | 5,7 | 1,5·10³ |

Die erfindungsgemäße OLED mit der lochinjlzierenden Schicht enthaltend die erfindungsgemäße Formulierung aus Beispiel 1 wies einen genügend hohen elektrischen Widerstand für die Anwendung in Passiv-Matrix OLEDs auf. Im Gegensatz dazu, war der Widerstand des Vergleichsbeispiels zu niedrig und elektrisches Übersprechen ("crosstalk") zwischen benachbarten Adresslinien wäre die Folge.

Ein weiterer Vorteil der erfindungsgemäßen OLED aus Beispiel 3 sind ihre höhere Effizienz und das deutlich günstigere Gleichrichtungsverhältnis im Vergleich zur OLED gemäß Vergleichsbeispiel.

### Beispiel 4

### Herstellung eines Poly(thieno[3,4-b]thiophen)/Polystyrolfulfonsäure-Komplexes und seine Mischung mit Nafion^{®}

Eine Lösung von 1,25 g PSS (Molekulargewicht M_{w} = 460 000 g/mol), 195,6g Wasser und 1,44 g 1%ige Eisen (III)-Sulfat-Lösung in Wasser wurden bei RT gerührt. 285 mg Thieno[3,4-b]thiophen wurden zugesetzt und die Lösung 1 h gerührt. 726 mg Natriumperoxodisulfat wurden zugesetzt. Nach 3 h Rühren erfolgte eine Zugabe von 215 mg Thieno [3,+b]thiophen und nach weiteren 15 min erfolgte eine Zugabe von 474 mg Natriumperoxodisulfat. Nach 18 h Rühren wurde die Mischung mit 10 g Kationentauscher und 6 g Anionenaustauscher (Lewatit^{®} S 100 und Lewatit^{®} MP 62) 8 h entionisiert und anschließend das lonenaustauscher-Harz abfiltriert. Die Dispersion der Poly(thieno[3,4-b]thiophen)/ Polystyrolfulfonsäure (PTT/PSS) wurde am Rotationsverdampfer auf das halbe Volumen aufkonzentriert.

Die entstandene Zubereitung wurde zur Herstellung der erfindungsgemäßen Mischung folgendermaßen abgemischt:
20 g obiger, entionisierter Zubereitung entsprechend 0,3 g PTT/PSS-Komplex
13 g Wasser
12,1 g Ethanol
13,82 g Liquion^{®} 1100 (Nafion^{®} enthaltende Lösung der Fa. Ion Power Inc., US; 5 gew.-%ige Lösung in 2-Propanol/H₂O, 1100 Äqu.)), entsprechend 0,64 g Nafion^{®}.
Dabei wurde zunächst Ethanol und Wasser zum Liquion^{®} 1100 zudosiert. ¼ h bei 23 °C gerührt und anschließend der PTT-PSS-Komplex zudosiert, wonach eine weitere ½ h bei 23 °C gerührt wurde.
Das Gewichtsverhältnis Monomer : PSS : Fluorpolymer entspricht 1 : 2,5 : 7,5

## Patentansprüche

1. Formulierung enthaltend
A) wenigstens ein Polythiophen enthaltend wiederkehrende Einheiten der allgemeinen Formel (I-a), 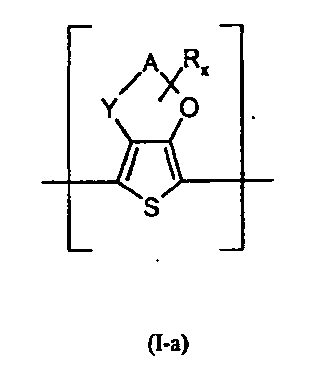 worin
A für einen gegebenenfalls substituierten C₁-C₅-Alkylenrest, bevorzugt für einen gegebenenfalls substituierten Ethylen- oder Propylenrest steht,
Y unabhängig voneinander für O oder S steht,
R für einen linearen oder verzweigten, C₁-C₁₈-Alkylrest, einen C₅-C₁₂-Cycloalkylrest, einen C₆-C₁₄-Arylrest, einen C₇-C₁₈-Aralkylrest, einen C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können,
wobei für den Fall, dass in der allgemeinen Formel (I-a) Y für O steht, das Polythiophen zudem wiederkehrende Einheiten der allgemeinen Formel (I-a), worin Y für S steht, enthält,
B) wenigstens ein SO₃⁻M⁺-Gruppen enthaltendes Polymer, wobei M⁺ für H⁺, Li⁺, Na⁺, K⁺, Rb⁺, Cs⁺ oder NH₄⁺, bevorzugt für H⁺, Na⁺ oder K⁺ steht, wobei das S0₃⁻M⁺-Gruppen enthaltende Polymer Polystyrolsulfonsäure ist, und
C) wenigstens ein SO₃⁻M⁺- oder COO-M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺, bevorzugt für H⁺, Na⁺ oder K⁺ steht
wobei das Gewichtsverhältnis von Polythiophen(en) A) zu dem(n) Polymer(en) B) von 1 zu 2 bis 1 zu 25 und das das Gewichtsverhältnis von Polythiophen(en) A) zu dem(n) teilfluoriertem(n) oder perfluoriertem(n) Polymer(en) C) von 1 zu 1 bis 1 zu 50 beträgt

2. Formulierung gemäße Anspruch 1, **dadurch gekennzeichnet, dass** wenigstens ein Polythiophen enthaltend wiederkehrende Einheiten der allgemeinen Formel (I-a) wiederkehrende Einheiten der allgemeinen Formel (I-aa) enthält, 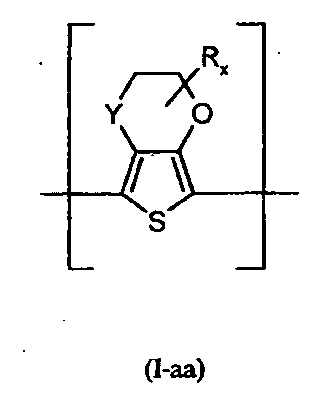 worin
R, Y und x die in Anspruch 1 genannte Bedeutung haben, bevorzugt x für 0 oder 1 steht.

3. Formulierung gemäß Anspruch 1 oder 2, **dadurch gekennzeichnet, dass** wenigstens ein Polythiophen enthaltend wiederkehrende Einheiten der allgemeinen Formel (I-a) wiederkehrende Einheiten der allgemeinen Formel (I-aa-1) und/oder (I-aa-2) und/oder (I-bb-1) enthält

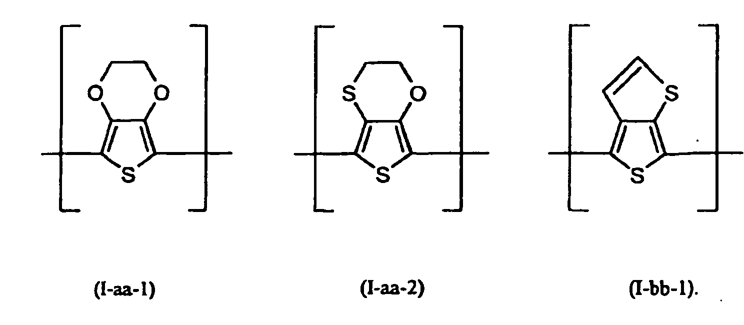

4. Formulierung gemäß wenigstens einem der Ansprüche 1 bis 3, **dadurch gekennzeichnet, dass** wenigstens ein Polythiophen enthaltend wiederkehrende Einheiten der allgemeinen Formel (I-a) ein Polythiophen enthaltend jeweils gleiche wiederkehrende Einheiten der allgemeinen Formel (I-a), worin Y für S steht, oder ein Copolymer enthaltend wiederkehrende Einheiten der allgemeinen Formel (I-a), worin Y sowohl für O als auch für S steht , ist.

5. Formulierung gemäß wenigstens einem der Ansprüche 1 bis 4, **dadurch gekennzeichnet, dass** sie zusätzlich zu wenigstens einem Polythiophen enthaltend wiederkehrende Einheiten der allgemeinen Formel (I-a) weitere leitfähige Polymere, wie Polyaniline, Polypyrrole oder Polythiophene, bevorzugt Poly(3,4-ethylendioxythiophen) enthält.

6. Formulierung gemäß wenigstens einem der Ansprüche 1 bis 5, **dadurch gekennzeichnet, dass** sie als wenigstens ein SO₃⁻M⁺- oder COO⁻M⁺-Gruppen enthaltendes teilfluoriertes oder perfluoriertes Polymer C) ein Copolymer aus Tetrafluorethylen und dem Trifluorvinylether des Poly(hexafluorpropylenoxid)mono(tetrafluorvinylsulfonsäure)-ethers enthält.

7. Formulierung gemäß wenigstens einem der Ansprüche 1 bis 6, **dadurch gekennzeichnet, dass** sie als wenigstens ein SO₃⁻M⁺- oder COO⁻M⁺-Gruppen enthaltendes teilfluoriertes oder perfluoriertes Polymer C) ein solches enthaltend wiederkehrende Einheiten der Formeln (II-a) und (IIb), 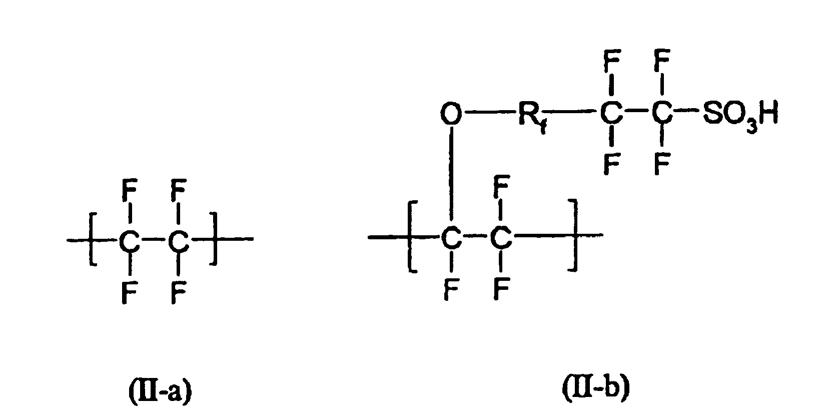 worin R_{f} für einen Rest mit wenigstens einer, bevorzugt 1 bis 30 wiederkehrenden Einheit(en) der Formel (II-c) steht, 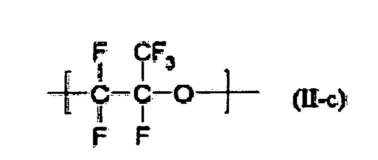 enthält.

8. Formulierung gemäß wenigstens einem der Ansprüche 1 bis 7, **dadurch gekennzeichnet, dass** das Gewichtsverhältnis von Polythiophen(en) A) zu SO₃⁻M⁺- oder COO⁻M⁺-Gruppen enthaltendem(n), teilfluoriertem(n) oder perfluoriertem(n) Polymer(en) C) von 1 zu 2 bis 1 zu 15 beträgt.

9. Formulierung gemäß wenigstens einem der Ansprüche 1 bis 8, **dadurch gekennzeichnet, dass** das Gewichtsverhältnis von Polythiophen(en) A) zu SO₃⁻M⁺-Gruppen enthaltendem(n) Polymer(en) B) von 1 zu 2 bis 1 zu 20 beträgt.

10. Formulierung gemäß wenigstens einem der Ansprüche 1 bis 9, **dadurch gekennzeichnet, dass** sie zusätzlich wenigstens ein polares Verdünnungsmittel enthält.

11. Formulierung gemäß Anspruch 10, **dadurch gekennzeichnet, dass** das polare Verdünnungsmittel D) Wasser ein Alkohol, insbesondere aus der Reihe Methanol, Ethanol, n-Propanol, 2-Propanol oder n-Butanol oder eine beliebige Mischung, enthaltend wenigstens eines dieser Verdünnungsmittel, verwendet werden.

12. Verfahren zur Herstellung einer Formulierung gemäß wenigstens einem der Ansprüche 1 bis 11, **dadurch gekennzeichnet, dass** eine Mischung enthaltend wenigstens ein SO₃⁻M⁺-Gruppen enthaltendes Polymer B) und wenigstens ein Polythiophen A), welche gegebenenfalls in Gegenwart eines Verdünnungsmittels in Form einer Lösung oder Dispersion vorliegen, mit wenigstens einem teilfluorierten oder perfluorierten, SO₃⁻M⁺- oder COO⁻M⁺-Gruppen enthaltenden Polymer C), welches gegebenenfalls in Gegenwart eines Verdünnungsmittels in Form einer Lösung oder Dispersion vorliegt, gemischt wird.

13. Verwendung der Formulierung gemäß wenigstens einem der Ansprüche 1 bis 11 zur Herstellung lochinjizierender oder lochtransportierender Schichten in elektrolumineszierenden Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

14. Elektrolumineszierende Anordnung, insbesondere eine Leuchtdiode, enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierenden Schicht zwischen einer der beiden Elektroden und der Emitter-Schicht, **dadurch gekennzeichnet, dass** die lochinjizierende Schicht eine Formulierung gemäß einem der Ansprüche 1 bis 11 enthält.

## Claims

1. Formulation containing
A) at least one polythiophene containing repeating units of the general formula (I-a), 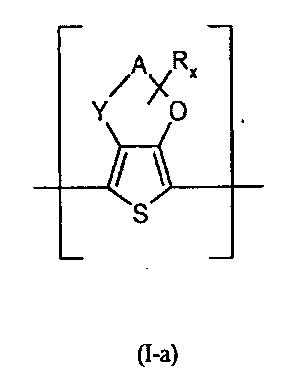 wherein
A stands for an optionally substituted C₁-C₅-alkylene radical, preferably for an optionally substituted ethylene or propylene radical,
Y, independent of each other, stands for O or S,
R stands for a linear or branched C₁-C₁₈-alkyl radical, a C₅-C₁₂-cycloalkyl radical, a C₆-C₁₄-aryl radical, a C₇-C₁₈-aralkyl radical, a C₁-C₄-hydroxyalkyl radical or a hydroxyl radical,
x stands for a whole number from 0 to 8 and
in the case that multiple radicals R are connected to A, these can be the same or different,
where in the case that Y stands for O in the general formula (I-a), the polythiophene additionally contains repeating units of the general formula (I-a), wherein Y stands for S,
B) at least one polymer which contains SO₃⁻M⁺ groups, wherein M⁺ stands for H⁺, Li⁺, Na⁺, K⁺, Rb⁺, Cs⁺ or NH₄⁺, preferably for H⁺, Na⁺ or K⁺, wherein the polymer which contains SO₃⁻M⁺ groups is polystyrene sulfonic acid, and
C) at least one partially fluorinated or perfluorinated polymer which contains either SO₃⁻M⁺ or COO⁻M⁺ groups, wherein M⁺ stands for H⁺, Li⁺, Na⁺, K⁺, Rb⁺, Cs⁺ or NH₄⁺, preferably for H⁺, Na⁺ or K⁺,
wherein the weight ratio of polythiophene(s) A) to the polymer(s) B) is from 1 : 2 to 1 : 25 and the weight ratio of polythiophene(s) A) to the partially fluorinated or perfluorinated polymer(s) C) is from 1 : 1 to 1 : 50.

2. Formulation according to claim 1, **characterised in that** at least one polythiophene which contains repeating units of the general formula (I-a) contains repeating units of the general formula (I-aa), 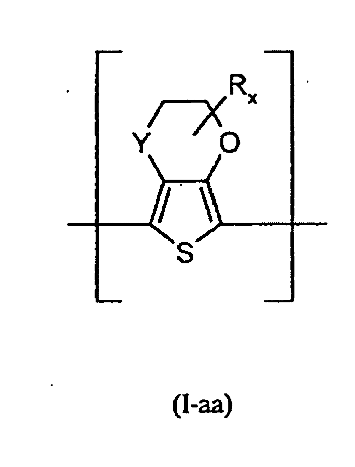 wherein
R, Y and x have the meanings named in claim 1, x preferably standing for 0 or 1.

3. Formulation according to claim 1 or 2, **characterised in that** at least one polythiophene which contains repeating units of the general formula (I-a) contains repeating units of the general formula (I-aa-1) and/or (I-aa-2) and/or (I-bb-1)

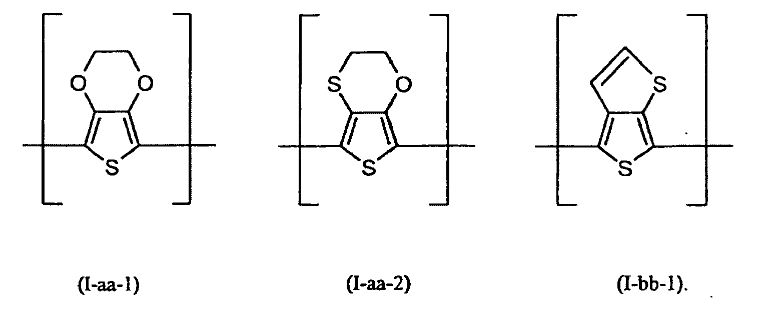

4. Formulation according to at least one of the claims 1 to 3, **characterised in that** at least one polythiophene which contains repeating units of the general formula (I-a) is a polythiophene which contains repeating units of the general formula (I-a) which are all the same, wherein Y stands for S, or a copolymer which contains repeating units of the general formula (I-a), wherein Y stands for both O and S.

5. Formulation according to at least one of the claims 1 to 4, **characterised in that** it contains, in addition to the at least one polythiophene which contains repeating units of the general formula (I-a), further conductive polymers, such as polyanilines, polypyrroles or polythiophenes, preferably poly(3,4-ethylenedioxythiophene).

6. Formulation according to at least one of the claims 1 to 5, **characterised in that** it contains, as the at least one partially fluorinated or perfluorinated polymer which contains SO₃⁻M⁺ or COO⁻M⁺ groups C), a copolymer of tetrafluoroethylene and the trifluorovinylether of the poly(hexafluoropropyleneoxide)mono(tetrafluorovinylsulphonic acid)ether.

7. Formulation according to at least one of the claims 1 to 6, **characterised in that** it contains, as the at least one partially fluorinated or perfluorinated polymer C) which contains SO₃⁻M⁺ or COO⁻M⁺ groups, such a polymer which contains repeating units of the formulae (II-a) and (II-b), 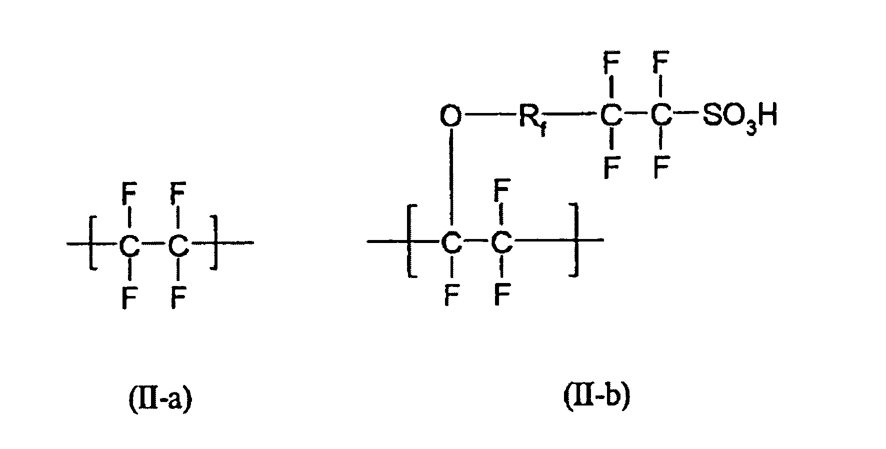 wherein R_{f} stands for a radical with at least one, preferably 1 to 30 repeating unit(s) of the formula (II-c).

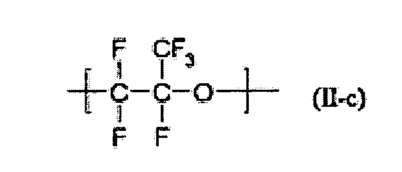

8. Formulation according to at least on of the claims 1 to 7, **characterised in that** the weight ratio of the polythiophene(s) A) to partially fluorinated or perfluorinated polymer(s) C) which contain(s) SO₃⁻M⁺ or COO⁻M⁺ groups is from 1 : 2 to 1 : 15.

9. Formulation according to at least one of the claims 1 to 8, **characterised in that** the weight ratio of the polythiophene(s) A) to polymer(s) B) which contain(s) SO₃⁻M⁺ groupsis from 1 : 2 to 1 : 20.

10. Formulation according to at least one of the claims 1 to 9, **characterised in that** it additionally contains at least one polar thinning agent.

11. Formulation according to claim 10, **characterised in that** water, an alcohol, in particular from the series methanol, ethanol, n-propanol, 2-propanol or n-butanol or any mixture which contains at least one of these thinning agents, is used as the polar thinning agent D).

12. Process for the preparation of a formulation according to at least one of the claims 1 to 11, **characterised in that** a mixture containing at least one polymer B) which contains SO₃⁻M⁺ groups and at least one polythiophene A), which are optionally in the form of a solution or dispersion in the presence of a thinning agent, are mixed with at least one partially fluorinated or perfluorinated polymer C) which contains SO₃⁻M⁺ or COO⁻M⁺ groups, which is optionally present in the form of a solution or dispersion in the presence of a thinning agent.

13. Use of the formulation according to at least one of the claims 1 to 11 for the preparation of hole injection layers of hole transport layers in electroluminescent devices, organic solar cells, organic laser diodes, organic thin film transistors or organic field effect transistors, for the preparation of electrodes or electrically conductive coatings.

14. Electroluminescent device, in particular a light emitting diode, containing at least two electrodes, of which optionally at least one is applied to an optionally transparent substrate, at least one emitter layer between the two electrodes and at least one hole injection layer between on of the tow electrodes and the emitter layer, **characterised in that** the hole injection layer contains a formulation according to one of the claims 1 to 11.

## Revendications

1. Formulation contenant
A) au moins un polythiophène contenant des unités répétées de formule générale (I-a) 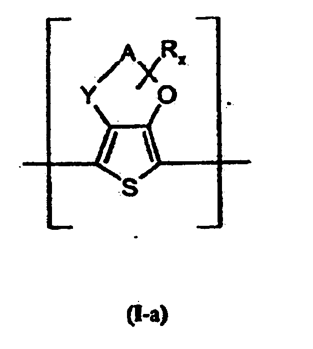 où
A représente un groupement C₁-C₅-alkylène éventuellement substitué, de préférence un groupement éthylène ou propylène éventuellement substitué,
Y représente indépendamment l'un de l'autre O ou S,
R représente un groupement C₁-C₁₈-alkyle linéaire ou ramifié, un groupement C₅-C₁₂cycloalkyle, un groupement C₆-C₁₄-aryle, un groupement C₇-C₁₈-aralkyle, un groupement C₁-C₄-hydroxyalkyle ou un groupement hydroxyle,
x représente un nombre entier de 0 à 8 et
pour le cas où plusieurs groupements R sont liés à A, ceux-ci peuvent être identiques ou différents,
où, pour le cas où, dans la formule générale (I-a), Y représente O, le polythiophène contient en outre des unités répétées de formule générale (I-a) où Y représente S,
B) au moins un polymère contenant des groupes SO₃-M⁺, où M⁺ représente H⁺, Li⁺, Na⁺, K⁺, Rb⁺, Cs⁺ ou NH₄⁺, de préférence H⁺, Na⁺ ou K⁺, où le polymère contenant des groupes SO₃⁻M⁺ est le poly(acide styrènesulfonique), et
C) au moins un polymère partiellement fluoré ou perfluoré contenant des groupes SO₃⁻M⁺ ou COO⁻M⁺, où M⁺ représente H⁺, Li⁺, Na⁺, K⁺, Rb⁺, Cs⁺ ou NH₄⁺, de préférence H⁺, Na⁺ ou K⁺,
où le rapport en poids du (des) polythiophène(s) A) au (aux) polymère(s) B) est de 1 : 2 à 1 : 25 et le rapport en poids du (des) polythiophène(s) A) au (aux) polymère(s) partiellement fluoré(s) ou perfluoré(s) C) est de 1 : 1 à 1 : 50.

2. Formulation selon la revendication 1 **caractérisée en ce qu'**au moins un polythiophène contenant des unités répétées de formule générale (I-a) contient des unités répétées de formule générale (I-aa) 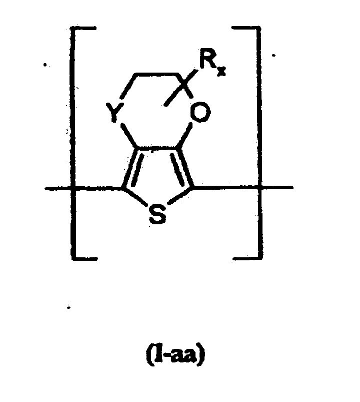 où
R, Y et x ont la signification citée dans la revendication 1, de préférence x représente 0 ou 1.

3. Formulation selon la revendication 1 ou 2 **caractérisée en ce qu'**au moins un polythiophène contenant des unités répétées de formule générale (I-a) contient des unités répétées de formule générale (I-aa-1) et/ou (I-aa-2) et/ou (I-bb-1)

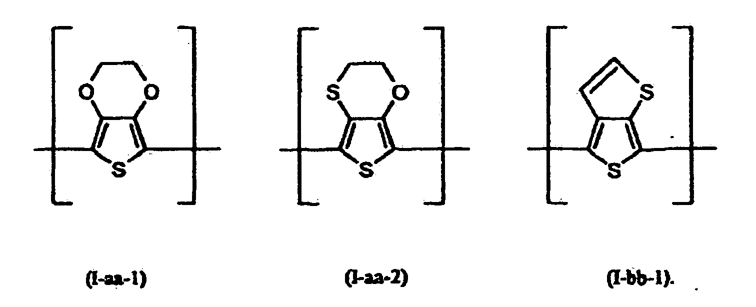

4. Formulation selon au moins l'une des revendications 1 à 3 **caractérisée en ce qu'**au moins un polythiophène contenant des unités répétées de formule générale (I-a) est un polythiophène contenant des unités répétées de formule générale (I-a) à chaque fois identiques, où Y représente S, ou un copolymère contenant des unités répétées de formule générale (I-a) où Y représente aussi bien O qu'également S.

5. Formulation selon au moins l'une des revendications 1 à 4 **caractérisée en ce qu'**elle contient en plus d'au moins un polythiophène contenant des unités répétées de formule générale (I-a) d'autres polymère conducteurs, comme des polyanilines, des polypyrroles ou des polythiophènes, de préférence du poly(3,4-éthylènedioxythiophène).

6. Formulation selon au moins l'une des revendications 1 à 5 **caractérisée en ce qu'**elle contient, comme au moins un polymère C) partiellement fluoré ou perfluoré contenant des groupes SO₃⁻M⁺ ou COO⁻M⁺ un copolymère de tétrafluoroéthylène et du trifluorovinyléther du poly(oxyde d'hexafluoropropylène)mono(acide tétrafluorovinyl-sulfonique)-éther.

7. Formulation selon au moins l'une des revendications 1 à 6 **caractérisée en ce qu'**elle contient, comme au moins un polymère C) partiellement fluoré ou perfluoré contenant des groupes SO₃⁻M⁺ ou COO⁻M⁺ un tel polymère contenant des unités répétées des formules (II-a) et (II-b) 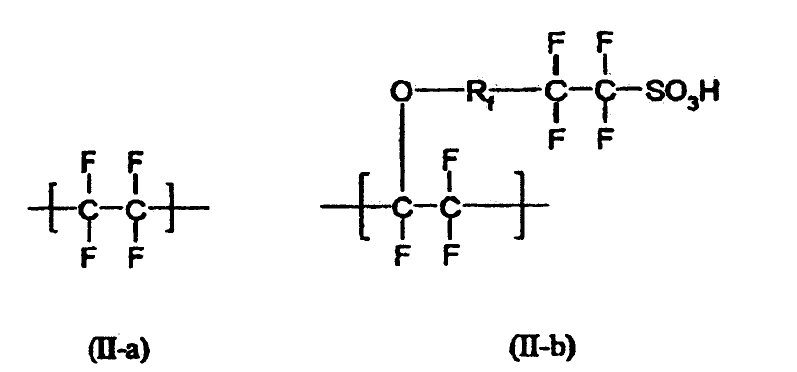 où R_{f} représente un groupement ayant au moins une, de préférence 1 à 30 unités répétées de formule (II-c)

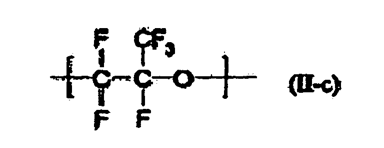

8. Formulation selon au moins l'une des revendications 1 à 7 **caractérisée en ce que** le rapport en poids du (des) polythiophène(s) A) au (aux) polymère(s) C) partiellement fluoré(s) ou perfluoré(s) contenant des groupes SO₃⁻M⁺ ou COO⁻M⁺ est de 1 : 2 à 1:15.

9. Formulation selon au moins l'une des revendications 1 à 8 **caractérisée en ce que** le rapport en poids du (des) polythiophène(s) A) au (aux) polymère(s) B) contenant des groupes SO₃⁻M⁺ est de 1 : 2 à 1 : 20.

10. Formulation selon au moins l'une des revendications 1 à 9 **caractérisée en ce qu'**elle contient en outre au moins un diluant polaire.

11. Formulation selon la revendication 10 **caractérisée en ce que** le diluant polaire D) l'eau, un alcool, en particulier de la série méthanol, éthanol, n-propanol, 2-propanol ou n-butanol ou un mélange quelconque, contenant au moins l'un de ces diluants, sont utilisés.

12. Procédé pour produire une formulation selon au moins l'une des revendications 1 à 11 **caractérisé en ce qu'**un mélange contenant au moins un polymère B) contenant des groupes SO₃⁻M⁺ et au moins un polythiophène A) qui sont présents éventuellement en présence d'un diluant sous forme d'une solution ou dispersion, est mélangé avec au moins un polymère C) partiellement fluoré ou perfluoré contenant des groupes SO₃⁻M⁺ ou COO⁻M⁺, qui est présent éventuellement en présence d'un diluant sous forme d'une solution ou dispersion.

13. Utilisation de la formulation selon au moins l'une des revendications 1 à 11 pour la production de couches injectant des trous ou transportant des trous dans des dispositifs électroluminescents, des cellules solaires organiques, des diodes laser organiques, des transistors à couches minces organiques ou des transistors à effet de champ organiques, pour la production d'électrodes ou de revêtements électriquement conducteurs.

14. Dispositif électroluminescent, en particulier diode luminescente, contenant au moins deux électrodes, parmi lesquelles éventuellement au moins l'une est appliquée sur un substrat éventuellement transparent, au moins une couche d'émetteur entre les deux électrodes et au moins une couche injectant des trous entre l'une des deux électrodes et la couche d'émetteur, **caractérisé en ce que** la couche injectant des trous contient une formulation selon l'une des revendications 1 à 11.
